# EUROPÄISCHE PATENTSCHRIFT

(11) **EP 4 035 510 B1**
(45) Veröffentlichungstag und Bekanntmachung des Hinweises auf die Patenterteilung: **03.04.2024**
(21) Anmeldenummer: 20776109.9
(22) Anmeldetag: 18.09.2020
(51) Int. Cl.: H05K 7/20

(54) **KÜHLSYSTEM UND KÜHLANORDNUNG**
COOLING SYSTEM AND COOLING ARRANGEMENT
SYSTÈME DE REFROIDISSEMENT ET AGENCEMENT DE REFROIDISSEMENT

(30) Priorität: 26.09.2019 DE 102019214728
(43) Veröffentlichungstag der Anmeldung: 03.08.2022
(73) Patentinhaber: Robert Bosch GmbH, 70442 Stuttgart (DE)
(72) Erfinder: PELZ, Frank, 71229 Leonberg (DE); MAGA, Iulian, 71642 Ludwigsburg (DE); LAMDIZIZ, Mohamed, 71672 Marbach A. N. (DE)
(86) Internationale Anmeldenummer: PCT/EP2020/076127
(87) Internationale Veröffentlichungsnummer: WO 2021/058397

(56) Entgegenhaltungen:
- US-A1- 2004 050 231
- US-A1- 2013 213 605

## Beschreibung

Die Erfindung betrifft ein Kühlsystem, ein Einzelmodulelement als Teil des Kühlsystems und eine das Kühlsystem umfassende Kühlanordnung gemäß dem Oberbegriff der unabhängigen Ansprüche.

### Stand der Technik

In vielen Elektronikschaltungen kommen elektrische und/oder elektronische Bauelemente zum Einsatz, die im Betrieb aufgrund von Verlustleistung eine messbare Temperaturerhöhung aufweisen. Insbesondere können durch große innere Leitungswiderstände und/oder hohe Betriebsströme nachteilige oder unzulässige Temperaturwerte erreicht werden, durch die der Betrieb der Elektronikschaltung ineffizient oder dessen Funktionssicherheit, insbesondere über die vorgesehene Lebensdauer, gefährdet ist. Aus diesen Gründen ist oft ein Entwärmungskonzept für temperaturgefährdete Bereiche der Elektronikschaltung vorzusehen. Bei sehr hohen Verlustleistung ist in manchen Anwendungen eine Entwärmung mittels eines Kühlmedium innerhalb einer Kühlvorrichtung erforderlich, wobei die temperaturgefährdeten Bereiche der Elektronikschaltung dann zumindest mittelbar mit der von dem Kühlmedium durchströmten Kühlvorrichtung zur Wärmeabfuhr verbunden sind.

Elektronikanwendung mit z.T. hohen Verlustleistungen findet man beispielsweise bei Steuergeräten, insbesondere im Automotivbereich. Hierbei sind hohe Anforderungen an die Betriebssicherheit gestellt, so dass der Entwärmung eine hohe Bedeutung zukommt. Moderne Vehicle Computer kommunizieren intern miteinander mittels eines schnellen Bussystems (Backbone) im Backplane. Durch die teilweise rasante Entwicklung in diesem Bereich besteht oft der Bedarf für ein Update-, Upgrade- bzw. einen Austausch im Fahrzeug sowohl auf einer Softwareebene als auch auf einer Hardwareebene der Elektronik. Dadurch wächst der Bedarf und die Nachfrage nach einer flexiblen Steuergeräteintegration gerade im Automotivbereich.

In der Serverindustrie werden bei hohen Verlustleistungen zwecks Entwärmung Servermodule in einer Kühlwanne eingetaucht, welche mit einer inerten Kühlflüssigkeit gefüllt ist. Dabei handelt es sich um stationäre Anwendungen mit großen Abmessungen und hohem Gewicht. Ähnliche Verlustleistungen werden zukünftig auch im Bereich des autonomen Fahrens auftreten. Hierbei fehlen allerdings für den Automotivbereich bauraumgerechte und kostengünstige Lösungen, welche die Abfuhr von hohen Verlustleistungen sicherstellen und eine einfache Austauschbarkeit der Elektronik zur Anpassung an den neuesten Entwicklungsstand berücksichtigen.

Aus der US 2013/213605 A1 ist ein Kühlsystem mit den Merkmalen des Oberbegriffs des Anspruchs 1 bekannt, bei dem im Wesentlichen eine beliebige Anzahl von zu kühlenden Einzelmodulelementen in Form von Radioeinheiten mittels mediendichter Verschlusskupplungen an einen gemeinsamen Kühlmittelstrang anschließbar sind. Zum Stoppen eines Fluidflusses während des Ersetzens eines Einzelmodulelements, um einen leckagefreien Austausch von Radioeinheiten zu ermöglichen, ist es bei der genannten Schrift vorgesehen, eine zur Erzeugung des Fluidflusses dienende Pumpe zeitweise auszuschalten.

Weiterhin ist es aus der US 2004/050231 A1 bekannt, modulare Pumpeinheiten an einen Mehrfachverteiler mittels flexibler Schläuche an Magnetventilen anzuschließen.

In der deutschen Offenlegungsschrift DE602005006310T2 ist eine Anordnung gezeigt, bei welcher einzelne Leistungsmodule gestapelt in einem gemeinsamen Fluidstrom angeordnet sind. Die Fluidrichtung und entsprechende Öffnungen für das Kühlmedium verlaufen dabei quer zu einer flachen Erstreckung der Leistungsmodule und deren elektrischen Anschlussebene. Ferner stellt jedes Leistungsmodul einen Teilabschnitt eines gemeinsamen Kühlkanals für das Kühlmedium bereit. Der Austausch eines Leistungsmodules ist sehr aufwändig, da die Anordnung vollständig demontiert und neu aufgebaut werden muss. Dabei muss auch das Kühlmedium für die Demontage abgelassen werden und nach der Neumontage wieder neu eingefüllt werden. Ein Betrieb der Anordnung ohne das auszutauschende Leistungsmodul ist nicht möglich, so dass sich bei einem Austausch ggf. zwangsläufig lange Stillstandszeiten ergeben, bei welcher die betreffende Elektronikanwendung nicht mehr zum Einsatz kommen kann.

### Offenbarung der Erfindung

### Vorteile

Der Erfindung liegt die Aufgabe zu Grunde, Elektronikeinheiten mit hoher Verlustleistung sicher zu entwärmen und dabei eine schnelle und einfache Austauschbarkeit zu ermöglichen. Insbesondere liegt der Erfindung die Aufgabe zugrunde, beim Hinzufügen und/oder Entfernen von Einzelmodulelementen des Kühlsystems auf einfache Art und Weise einen Kühlmittelverlust zu vermeiden.

Diese Aufgabe wird durch ein Kühlsystem, ein Einzelmodulelement als Teil des Kühlsystems und eine das Kühlsystem umfassende Kühlanordnung gemäß den unabhängigen Ansprüchen gelöst.

Ausgegangen wird von einem Kühlsystem mit einem geschlossenen Kühlkanalsystem, welches zwischen einem Haupteinlass und einem Hauptauslass für ein Kühlmedium ausgebildet ist und zumindest einen Kühlkanalstrang umfasst. Dabei ist das Kühlsystem aus zwei oder mehreren Einzelmodulelementen gebildet, wobei jedes Einzelmodulelement jeweils zumindest einen Teilabschnitt des Kühlkanalsystems bzw. des zumindest einen Kühlkanalstrang umfasst. Dabei schließen sich in einem insbesondere lösbaren Verbindungsbereich beider Einzelmodulelemente zueinander deren jeweils umfasste zumindest ein Teilabschnitt fortlaufend zu dem zumindest einen Kühlkanalstrang an. Die benachbarten Einzelmodulelemente weisen ferner im Verbindungsbereich jeweils ein komplementäres Elemente einer gemeinsamen Medienkupplung auf, insbesondere als Verschlusskupplung, bei welcher in einer gelösten Verbindung zwischen beiden benachbarten Einzelmodulelementen der jeweilige in einem Einzelmodulelement enthaltene Teilabschnitt zumindest in dessen Verbindungsbereich mediendicht verschlossen ist und in einer gekuppelten Verbindung zwischen beiden benachbarten Einzelmodulelementen im Verbindungsbereich ein Durchgang für einen Kühlmediumfluss innerhalb der Medienkupplung geöffnet ist. Auf diese Weise ist ein Zusammenbau von mehreren Einzelmodulelementen zu dem Kühlsystem sehr einfach ermöglicht. Dabei kann ein bestehendes Kühlsystem vorteilhaft durch Hinzufügen oder Entfernen von zumindest einem Einzelmodulelement in der Größe angepasst werden. Eine Anpassung kann hierbei in vorteilhafter Weise jederzeit ohne einen Kühlmediumverlust und der Erfordernis eines Nachfüllens von Kühlmedium erfolgen. In einer besonderen Ausführung kann zumindest einer der Einzelmodulelemente oder alle Einzelmodulelemente integral eine Elektronikeinheit umfassen, welche zumindest mittelbar im thermischen Kontakt zur Teilabschnitt des zumindest einen Kühlkanalstrangs steht. Weiterhin ist es erfindungsgemäß vorgesehen, dass das Kühlsystem als ein Grundkühlmodul ausgebildet ist, welches den zumindest einen Kühlkanalstrang als ein Basiskühlkanalsystem umfasst. Zusätzlich weist das Basiskühlkanalsystem mindestens zwei Nebenanschlüsse auf mittels welchen das Basiskühlkanalsystem außerhalb des Grundkühlmodules durch eine lösbare Verbindung mit zumindest einer Kühlstrecke einer externen Kühlvorrichtung erweiterbar ist. Zusätzlich bevorzugt ist bei einer derartigen Verbindung der Kühlstrecke diese dabei als paralleler Nebenstrang zu einem zwischen den verbundenen Nebenanschlüssen ausgebildeten Teilabschnitt des Basiskühlkanalsystems angeschlossen bzw. anschließbar. Alternativ sind mittels der Kühlstrecke in einer solchen Verbindung zwei voneinander getrennte Kühlkanalstränge überbrückend miteinander verbunden bzw. verbindbar. In vorteilhafter Weise stehen damit Kühlstrecken angeschlossener unterschiedlicher Kühlvorrichtungen nur mittelbar über das Grundkühlmodul in einem gemeinsamen dann erweiterten Kühlkanalsystem in Verbindung, so dass einzelne angeschlossene Kühlvorrichtungen unabhängig von anderen im Kühlsystem verbundenen Kühlvorrichtungen einfach aus dem Kühlsystem wieder entfernt werden können oder unabhängig von den anderen Kühlvorrichtungen ins Kühlsystem neu eingebunden werden können. Dabei stellen die Nebenanschlüsse des Basiskühlkanalsystems innerhalb des Grundkühlmodules die einzigen Schnittstellen für das Kühlmedium in Hinblick auf eine anschließbare Kühlvorrichtung dar. Auf diese Weise ist eine einfache und hoch effiziente Austauschbarkeit von Elektronikmodulen innerhalb des gesamten Kühlsystems ermöglicht, wobei ein Elektronikmodul beispielsweise eine Elektronikeinheit aufweist und diese zumindest mittelbar in thermischem Kontakt zu einer zuvor genannten anschließbaren Kühlvorrichtung steht. Das Grundkühlmodul stellt demnach eine Art Verteilerbasis für ein Kühlmedium bereit für ein oder mehrere anschließbare Kühlvorrichtungen, insbesondere als Teil eines Elektronikmodules. Beim Entfernen einer einzelnen Kühlvorrichtung ist ein Kühlmediumfluss innerhalb des Basiskühlkanalsystems und den ggf. noch im Kühlsystem verbundenen anderen Kühlvorrichtungen weiterhin einfach möglich. Das liegt daran, dass alle freiliegenden Nebenanschlüsse lediglich mediendicht verschlossen sein müssen. Dies kann in einfacher Weise beispielsweise durch ein Verschlusselement erfolgen, welches beispielsweise als Steck- oder Schraubverschluss ausgeführt ist. Demnach kann der Betrieb des Kühlsystems und damit beispielsweise die Entwärmung einer zumindest mittelbar mit dem Kühlsystem thermisch leitverbundenen Elektronikeinheit aufrechterhalten werden und Stillstandszeiten der damit verbundenen Elektronikanwendung vermieden werden.

Zusätzlich weist das Basiskühlkanalsystem mindestens zwei Nebenanschlüsse auf, mittels welchen das Basiskühlkanalsystem außerhalb des Grundkühlmodules durch eine lösbare Verbindung mit zumindest einer Kühlstrecke einer externen Kühlvorrichtung erweiterbar ist. Zusätzlich bevorzugt ist bei einer derartigen Verbindung der Kühlstrecke diese dabei als paralleler Nebenstrang zu einem zwischen den verbundenen Nebenanschlüssen ausgebildeten Teilabschnitt des Basiskühlkanalsystems angeschlossen bzw. anschließbar. Alternativ sind mittels der Kühlstrecke in einer solchen Verbindung zwei voneinander getrennte Kühlkanalstränge überbrückend miteinander verbunden bzw. verbindbar. In vorteilhafter Weise stehen damit Kühlstrecken angeschlossener unterschiedlicher Kühlvorrichtungen nur mittelbar über das Grundkühlmodul in einem gemeinsamen dann erweiterten Kühlkanalsystem in Verbindung, so dass einzelne angeschlossene Kühlvorrichtungen unabhängig von anderen im Kühlsystem verbundenen Kühlvorrichtungen einfach aus dem Kühlsystem wieder entfernt werden können oder unabhängig von den anderen Kühlvorrichtungen ins Kühlsystem neu eingebunden werden können. Dabei stellen die Nebenanschlüsse des Basiskühlkanalsystems innerhalb des Grundkühlmodules die einzigen Schnittstellen für das Kühlmedium in Hinblick auf eine anschließbare Kühlvorrichtung dar. Auf diese Weise ist eine einfache und hoch effiziente Austauschbarkeit von Elektronikmodulen innerhalb des gesamten Kühlsystems ermöglicht, wobei ein Elektronikmodul beispielsweise eine Elektronikeinheit aufweist und diese zumindest mittelbar in thermischem Kontakt zu einer zuvor genannten anschließbaren Kühlvorrichtung steht. Das Grundkühlmodul stellt demnach eine Art Verteilerbasis für ein Kühlmedium bereit für ein oder mehrere anschließbare Kühlvorrichtungen, insbesondere als Teil eines Elektronikmodules. Beim Entfernen einer einzelnen Kühlvorrichtung ist ein Kühlmediumfluss innerhalb des Basiskühlkanalsystems und den ggf. noch im Kühlsystem verbundenen anderen Kühlvorrichtungen weiterhin einfach möglich.

Das liegt daran, dass alle freiliegenden Nebenanschlüsse lediglich mediendicht verschlossen sein müssen. Dies kann in einfacher Weise beispielsweise durch ein Verschlusselement erfolgen, welches beispielsweise als Steck- oder Schraubverschluss ausgeführt ist. Demnach kann der Betrieb des Kühlsystems und damit beispielsweise die Entwärmung einer zumindest mittelbar mit dem Kühlsystem thermisch leitverbundenen Elektronikeinheit aufrechterhalten werden und Stillstandszeiten der damit verbundenen Elektronikanwendung vermieden werden.

Zusätzlich stellt das Grundkühlmodul eine Art mechanische Verbundbasis dar, mittels welcher eine Anordnung von angeschlossenen Kühlvorrichtungen mechanisch fest im Verbund bestehen bleiben kann. Ferner ist durch die Bereitstellung des Basiskühlkanalsystems innerhalb des Grundkühlmodules die Möglichkeit einer modularen Skalierung einer erforderlichen Größe eines Kühlsystems gegeben. Eine maximale Skalierung ist dabei durch die Anzahl von bereitgestellten Nebenanschlüssen innerhalb des Basiskühlkanalsystems bestimmt. Die Größe des Kühlsystems lässt sich damit dann in Abhängigkeit der Anzahl von verbundenen externen Kühlvorrichtungen und somit durch die Anzahl der dann zusätzlich mit dem Basiskühlkanalsystem verbundenen Kühlstrecken der einzelnen externen Kühlvorrichtungen variierbar bzw. bewusst definiert einstellen. Die lösbare und insbesondere mediendichte Verbindung erlaubt eine schnelle und einfache Skalierung des Kühlsystems durch das Einbinden oder Entfernen von externen Kühlvorrichtungen. Denkbar sind hier beliebig bekannte Lösungen, insbesondere umfassend einen Kraft- und/oder Formschluss. Beispielhaft sind Verbindungslösungen in Form einer Schraubverbindung, einer mediendichten Steckverbindung, einer federunterstützen Anpressverbindung, einer Kupplungsverbindung und/oder in Form einer anderen lösbaren Verbindungsausführung denkbar. Als Kühlmedium kommen Kühlgase oder Kühlflüssigkeiten in Frage, insbesondere Kühlwasser oder eine inerte Kühlflüssigkeit, falls ein elektrischer Kontakt mit einer zu entwärmenden Elektronikeinheit aufgrund des vorgesehenen Entwärmungskonzeptes vorliegt oder nicht auszuschließen ist. Im Betrieb ist das Kühlsystem über den Haupteinlass und den Hauptauslass mit einer Medienpumpe verbunden, mittels welcher ein Kühlmediumfluss innerhalb des Kühlsystems erwirkt wird, beispielsweise in Form eines geschlossenen Kühlkreislaufes. Das Kühlmedium durchfließt im Betrieb zumindest einen geschlossenen Kühlkanalstrang und/oder überbrückt verbundenen Kühlkanalstrang innerhalb des Grundkühlmodules und falls eine externe Kühlvorrichtung mit entsprechenden Nebenanschlüssen verbunden ist auch dessen dann verbundene Kühlstrecke.

Eine vorteilhafte Ausführungsform des Kühlsystems zeigt sich darin, dass zumindest ein Paar von Nebenanschlüssen genau einem oder zumindest einem durchgehenden Kühlkanalstrang und/oder zumindest ein Paar von Nebenanschlüssen genau zwei oder mindestens zwei voneinander getrennten Kühlkanalsträngen zugeordnet sind, so dass die Kühlstrecke mindestens einer externen Kühlvorrichtung als paralleler Nebenstrang an dem jeweils zumindest einen zugeordneten Kühlkanalstrang anschließbar ist und/oder die zumindest beiden zugeordneten voneinander getrennten Kühlkanalsträngen durch die Kühlstrecke überbrückend miteinander verbindbar sind. Bevorzugt umfasst bei zwei getrennten Kühlkanalsträngen einer der Kühlkanalstränge den Haupteinlass und der andere den Hauptauslass des Kühlsystems. Weiter bevorzugt sind die zwei voneinander getrennten Kühlkanalstränge parallel zueinander innerhalb des Grundkühlmodules ausgebildet, wobei der Haupteinlass und der Hauptauslass insbesondere jeweils in einem Endbereich der voneinander getrennten Kühlkanalstränge angeordnet sind. Grundsätzlich können der Haupteinlass und der Hauptauslass dann insbesondere auf der gleichen Seite des Grundkühlmodules oder alternativ auf gegenüberliegenden Seiten des Grundkühlmodules angeordnet sein. Insgesamt ergibt sich dadurch eine gut zugängliche Anschlussmöglichkeit des Grundkühlmodules an eine Medienpumpe.

Bei einem durchgehenden Kühlkanalstrang ergeben sich mehrere mögliche parallele Nebenstränge bevorzugt durch eine paarweise von außen nach innen vorgesehene fortlaufende Anordnung nächstbenachbarter Nebenanschlüsse. Weiter bevorzugt ist der zumindest eine durchgehende Kühlkanalstrang dabei u-förmig innerhalb des Grundkühlmodules ausgebildet, wobei der Haupteinlass und der Hauptauslass insbesondere auf der gleichen Seite des Grundkühlmodules in den Endbereichen des durchgehenden Kühlkanalstranges angeordnet sind. Insgesamt ist dadurch eine hohe Kompaktheit des Kühlsystems auch bei angeschlossenen externen Kühlvorrichtungen sichergestellt.

Eine vorteilhafte Ausführungsform des Kühlsystems sieht dabei vor, dass zumindest ein oder alle Einzelmodulelemente genau zwei Nebenanschlüsse aufweist/aufweisen, die jeweils mit dem Moduleinlass und dem Modulauslass einer externen Kühlvorrichtung verbindbar sind. Insofern entspricht die Anzahl an Einzelmodulen genau der Anzahl an anschließbaren externen Kühlvorrichtungen. Dadurch bleibt das Modulkonzept in der Fertigung und in der Handhabung sehr übersichtlich und kosteneffizient.

In einer besonderen Ausführungsform des Kühlsystems ist in zumindest einem oder in allen Einzelmodulelementen jeweils ein Überbrückungskühlkanalstrang ausgebildet, welcher innerhalb des Einzelmodulelementes in zwei umfasste Teilabschnitte des zumindest einen Kühlkanalstrangs mündet. Dabei weist das Einzelmodulelement mindestens drei Nebenanschlüsse auf, von denen jeweils zwei mit einer externen Kühlvorrichtung verbindbar sind, so dass die Kühlstrecke der externen Kühlvorrichtung als paralleler Nebenstrang zu einem zwischen den verbindbaren Nebenanschlüssen ausgebildeten Teilabschnitt des Überbrückungskühlkanalstrangs anschließbar ist. Auf diese Weise kann in dem zum Basiskühlkanalsystem anschließbaren parallelen Nebenstrang zur Erweiterung noch mehrere externe Kühlvorrichtungen genutzt werden. Alternativ ist eine Anschlusswahlmöglichkeit gegeben, durch die externe Kühlvorrichtungen mit unterschiedlichen Anschlussmaßen anschließbar sind. Dabei sind Anschlussmaße ermöglicht, die der Beabstandung von zwei beliebigen Nebenanschlüssen innerhalb des Einzelmodulelementes entspricht. Insgesamt ist dadurch die Flexibilität des Kühlsystems weiter erhöht.

Grundsätzlich ist es vorteilhaft, dass zur Erwirkung eines mechanisch gehaltenen Verbundkörpers die Einzelmodulelemente unter Ausbildung des Grundkühlmodules kraft- und/oder formschlüssig verbunden sind. Dies kann insbesondere mittels eines lösbaren Verbindungssystems, umfassend eine Schraubverbindung, eine Rastverbindung, eine Steckverbindung oder einen Bügelverschluss, erfolgen. Es sind auch andere lösbare Verbindungsausführungen denkbar.

Ferner ist in einer günstigen Ausführungsform des Kühlsystems berücksichtigt, dass das Grundkühlmodul zumindest ein Befestigungselement aufweist, welches als komplementäres Element eines lösbaren gemeinsamen Befestigungssystems mit einer externen Kühlvorrichtung zur deren gemeinsamen ausschließlich mechanischen Befestigung zueinander ausgebildet ist. Das Befestigungssystem ist bevorzugt als Schraubverbindung, als Rastverbindung, als Steckverbindung oder als Bügelverschluss ausgelegt. Insgesamt kann dadurch ein Verbund von dem Grundkühlmodul und einer oder mehreren angeschlossenen externen Kühlvorrichtungen auch mechanischen Krafteinwirkungen standhalten, insbesondere als zumindest Teil eines Kühlsystems eines Kraftfahrzeuges, welches in vielfacher Weise dynamisch kraftbeansprucht ist.

In einer Weiterbildung des Kühlsystems weisen die Nebenanschlüsse jeweils ein steuerbares oder regelbares, insbesondere elektrisch steuerbares oder regelbares, Durchflussventil zur Einstellung eines Volumenstromes des Kühlmediums auf. Dadurch kann ein Entwärmungsvermögen einer angeschlossenen externen Kühlvorrichtung auf den tatsächlichen Entwärmungsbedarf variabel oder definiert eingestellt sein. Auf diese Weise kann ein die Kühlvorrichtung enthaltenes Elektronikmodul in einem definierten Betriebstemperaturfenster betrieben werden. Insgesamt ergibt sich dadurch ein energieeffizienter und ein auf den Anwendungsfall zugeschnittener Betrieb des Kühlsystems. Zusätzlich oder alternativ kann zu diesem Zweck das Basiskühlkanalsystem Teilabschnitte unterschiedlicher Querschnittsgrößen aufweisen, so dass ein ermöglichter Volumenstrom des Kühlmediums zwischen zumindest zwei Paaren von Nebenanschlüssen sich unterscheidet.

Die Erfindung betrifft auch ein Einzelmodulelement eines Kühlsystems in zumindest einer der zuvor beschriebenen Ausführungsformen. Das Einzelmodulelement umfasst dabei bevorzugt zumindest ein komplementäres Element einer gemeinsamen Medienkupplung eines mit dem Einzelmodulelement verbindbaren weiteren Einzelmodulelementes, welches das passende andere komplementäre Element der gemeinsamen Medienkupplung aufweist.

Die Erfindung führt auch zu einer Kühlanordnung umfassend zumindest ein Kühlsystem nach zumindest einer der zuvor beschriebenen Ausführungsformen. Dabei sind zumindest zwei Nebenanschlüsse mit einer Kühlstecke einer externen Kühlvorrichtung verbunden. Bevorzugt ist hierbei die Kühlvorrichtung Teil eines Elektronikmodules mit einer Elektronikeinheit. Diese ist dabei zur Abführung von Verlustwärme zumindest in einem Teilbereich zumindest mittelbar wärmeleitend mit der Kühlvorrichtung verbunden. Weisen die angeschlossenen Nebenanschlüsse jeweils die zuvor genannten Durchflussventile auf, so sind diese aufgrund der Verbindung in der ersten Betätigungsstellung eingestellt, so dass ein Kühlmediumfluss zwischen dem Basiskühlkanalsystem und der verbundenen Kühlstrecke ermöglicht ist. Gleiches gilt für den Fall, dass zwischen den Nebenanschlüssen und einer externen Kühlvorrichtung eine Medienkupplung im gekuppelten Zustand vorliegt.

Bevorzugt ist das Elektronikmodul, umfassend die Kühlvorrichtung, ein Leistungsmodul, beispielsweise ein Steuergerät, insbesondere für ein Kraftfahrzeug. Weiter bevorzugt ist die Kühlanordnung Teil eines Vehicle Computers, insbesondere zusätzlich umfassend ein Bussystem, über welches Elektronikmodule, bevorzugt in Form eines Steuergerätes, in einem Gesamtsystem integriert sind.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
- Fig. 1:: eine Anordnung eines Kühlsystems und zumindest eines mit dem Kühlsystem verbindbaren Elektronikmoduls mit einer Elektronikeinheit und einer Kühlvorrichtung in einer perspektivischen Darstellung,
- Fig. 2a:: ein beispielhaftes Basiskühlkanalsystem eines Kühlsystems in einer perspektivischen Darstellung,
- Fig. 2b:: ein Ausführungsbeispiel eines modularen Kühlsystems in einer perspektivischen Darstellung.
- Fig. 2c:: ein Einzelmodulelement mit einem Überbrückungskühlkanalstrang, dargestellt in einem Schnitt durch die umfassten Durchflussventile,
- Fig. 3a:: eine schematische Darstellung eines Durchflussventiles umfassend eine Feder,
- Fig. 3b:: eine schematische Darstellung eines Durchflussventiles umfassend einen Magneten,
- Fig. 3c:: eine schematische Darstellung eines Durchflussventiles umfassend eine elektrische Spule.

### Ausführungsformen der Erfindung

In den Figuren sind funktional gleiche Bauelemente jeweils mit gleichen Bezugszeichen gekennzeichnet.

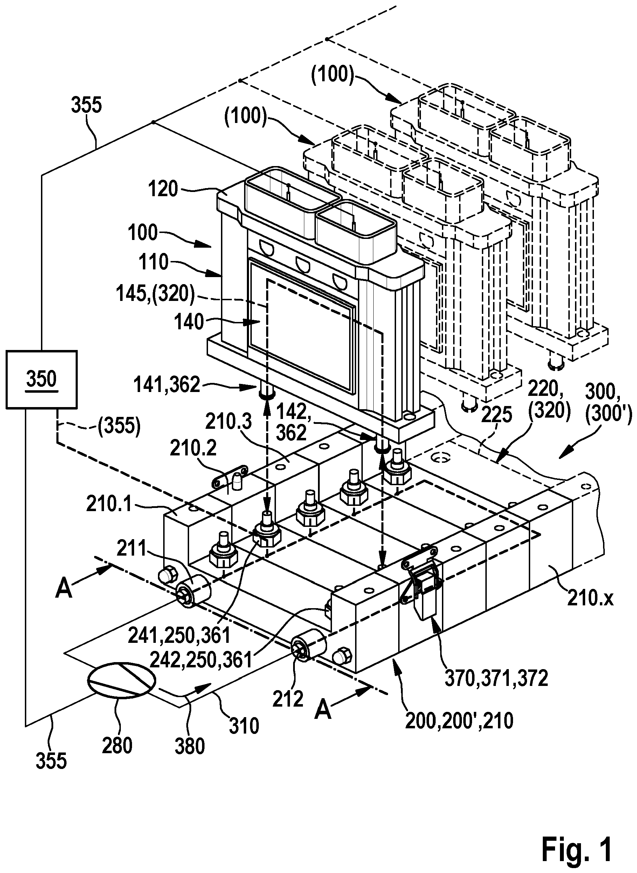

Die Fig. 1 zeigt in einer perspektivischen Darstellung eine Anordnung 300 mit einem Kühlsystem 200 und zumindest einem von dem Kühlsystem 200 gelösten, aber mit diesem verbindbaren Elektronikmodul 100.

Das Elektronikmodul 100 weist ein Gehäuse 110 auf, in welchem eine Elektronikeinheit verschlossen aufgenommen ist. Zusätzlich weist das Elektronikmodul 100 eine Kühlvorrichtung 140 auf, mit welcher zur Abführung von Verlustwärme zumindest ein Teilbereich der Elektronikeinheit wärmeleitend verbunden ist. Hierbei wird die Kühlvorrichtung 140 von einem Kühlmedium 310 durchströmt, welches Verlustwärme von der Elektronikeinheit aufnehmen kann, beispielsweise ein Kühlgas oder eine Kühlflüssigkeit. Hierfür weist das Elektronikmodul 100 einen Moduleinlass und ein Modulauslass 141, 142 für das Kühlmedium 310 auf. Zwischen dem Moduleinlass und dem Modulauslass 141, 142 ist eine Kühlstrecke 145 der Kühlvorrichtung 140 ausgebildet, durch welche das Kühlmedium 310 geführt wird. Bei einer bestehenden Verbindung zumindest eines Elektronikmodules 100 mit dem Kühlsystem 200 ist eine Kühlanordnung 300' ausgebildet, durch welche mittels des Kühlsystems 200 eine Entwärmung verbundener Elektronikmodule 100 erfolgen kann. Dabei ist das Kühlmedium 310 und die Aufrechterhaltung eines Kühlmediumflusses durch das Kühlsystem 200 in einem gesamtheitlichen geschlossenen Kühlkanalsystem 320 bereitgestellt. Hierfür ist das Kühlsystem 200 als ein Grundkühlmodul 200' mit einem Basiskühlkanalsystem 220 ausgebildet und stellt demnach eine Art Verteilerbasis für das Kühlmedium 310 bereit für ein oder mehrere anschließbare externe Kühlvorrichtungen 140, insbesondere als Teil eines Elektronikmodules 100, wie im vorliegenden Ausführungsbeispiel gezeigt. Das Basiskühlkanalsystem 220 umfasst dabei zumindest einen zwischen einem Haupteinlass und einem Hauptauslass 211, 212 für das Kühlmedium 310 angeordneten Kühlkanalstrang 225. Das gesamtheitliche geschlossene Kühlkanalsystem 320 setzt sich damit zusammen aus dem Basiskühlkanalsystem 220 des Grundkühlmoduls 200' und jeder damit verbundenen Kühlstrecke 145 einer externen Kühlvorrichtung, insbesondere der Kühlvorrichtung 140 eines Elektronikmodules 100. Das Basiskühlkanalsystem 220 ist demnach durch jede verbundene Kühlstrecke 145 einer externen Kühlvorrichtung 140 erweiterbar. Zur Verbindung weist das Basiskühlkanalsystem 220 mindestens zwei Nebenanschlüsse 241, 242 auf. Diese weisen jeweils einen direkten Zugang zu dem zumindest einen Kühlkanalstrang 220 auf. Der Haupteinlass 211 und der Hauptauslass 212 sind zumindest mittelbar mit einer Medienpumpe 280 verbunden, durch welche ein Kühlmediumfluss durch das Kühlkanalsystem 220 und eine verbundene Kühlstrecke 145, beispielsweise innerhalb eines geschlossenen Kühlkreislaufes 380 aufrechterhalten werden kann. Die Medienpumpe 280 ist ferner beispielsweise mit einer Steuer- oder Regelsystem 350 verbunden zur definierten Einstellung einer Pumpendrehzahl. Mit dem Steuer- oder Regelsystem 350 ist beispielsweise auch ein Steckverbinder 120 mindestens eines Elektronikmoduls 100 elektrisch verbunden. Die Verbindung des Steuer- oder Regelsystems 350 mit der Medienpumpe 280 und/oder zumindest einem Elektronikmodul 100 erfolgt bevorzugt mittels eines Bussystems 355.

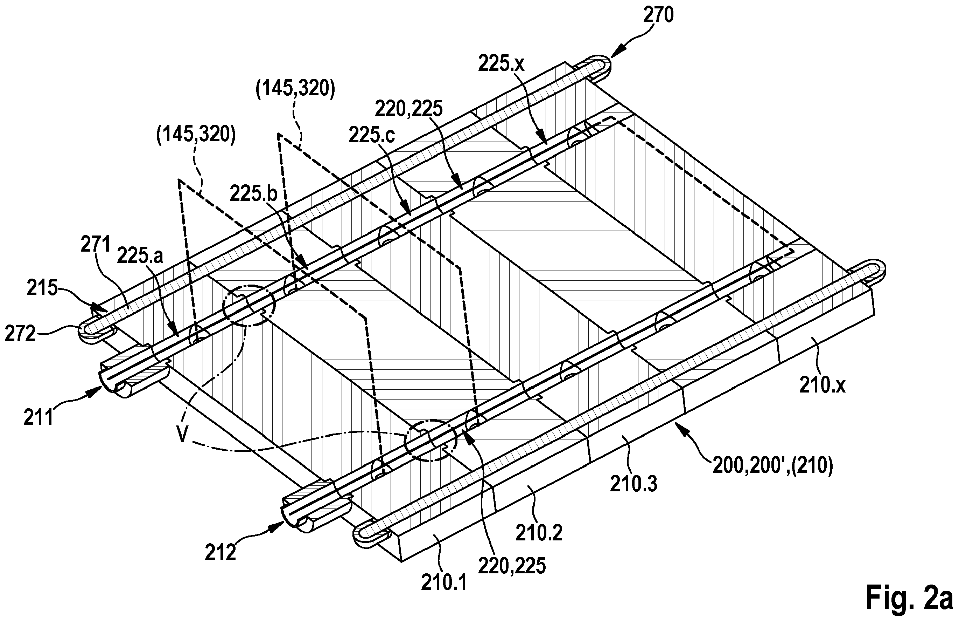

In Fig. 2a ist das Grundkühlmodul 200' in einer geschnittenen Darstellung A-A gezeigt. Die Schnittebene ist gerade durch den Kanalverlauf des Basiskühlkanalsystems 220 gelegt. Das Basiskühlkanalsystem 220 kann anwendungsspezifisch sehr unterschiedlich gestaltet sein. In einer einfachen Ausführung ist das Basiskühlkanalsystem 220 aus zwei voneinander getrennten Kühlkanalsträngen 225 gebildet, wobei der Haupteinlass und der Hauptauslass 211, 212 bevorzugt jeweils in einem Endbereich der voneinander getrennten Kühlkanalstränge 225 angeordnet sind. Diese können dann auf der gleichen Seite des Grundkühlmodules 200' oder auf gegenüberliegenden Seiten des Grundkühlmodules 200` (nicht dargestellt) angeordnet sein. In einer anderen einfachen Ausführung ist zumindest ein durchgehender Kühlkanalstrang 225 u-förmig als das Basiskühlkanalsystem 220 innerhalb des Grundkühlmodules 200' ausgebildet (gestrichelt dargestellt). Dabei sind der Haupteinlass und der Hauptauslass 211, 212 auf der gleichen Seite des Grundkühlmodules 200' in den Endbereichen des durchgehenden Kühlkanalstrangs 225 angeordnet.

Allgemein ist bei allen Ausführungsmöglichkeiten das zumindest eine Paar von Nebenanschlüssen 241, 242 genau einem oder zumindest einem durchgehenden Kühlkanalstrang 225 zugeordnet. Auf diese Weise sind Kühlstrecken 145 externer Kühlvorrichtungen 140 als jeweils paralleler Nebenstrang anschließbar. Alternativ oder zusätzlich kann das zumindest eine Paar von Nebenanschlüssen 241, 242 genau zwei oder mindestens zwei voneinander getrennten Kühlkanalsträngen 225 zugeordnet sein, wodurch diese durch die Kühlstrecke 145 einer externen Kühlvorrichtung 140 überbrückend miteinander verbindbar sind.

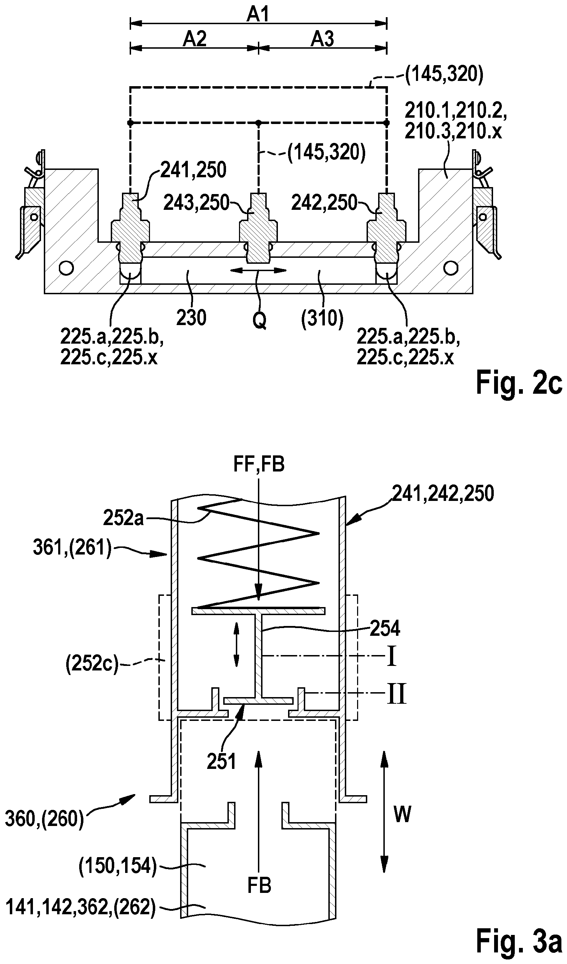

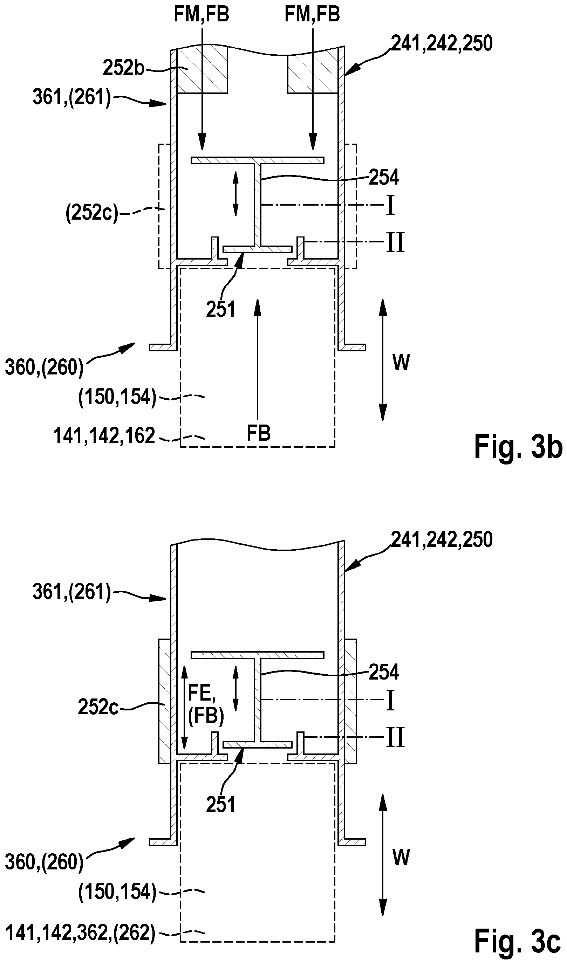

Ein Nebenanschluss 241, 242 umfasst bzw. stellt dabei jeweils ein Durchflussventil 250 für das Kühlmedium 310 dar. Dabei ist das Durchflussventil 250 ausgebildet in einer ersten Betätigungsstellung I das Basiskühlkanalsystem 220 für den Kühlmediumfluss zu öffnen und in einer zweiten Betätigungsstellung II das Basiskühlkanalsystem 220 mediendicht zu verschließen. Grundsätzlich kann ein solches Durchflussventil 250 konstruktiv unterschiedlich ausgeführt sein. In den Fig. 3a - 3c sind bevorzugte Lösungsprinzipien schematisch dargestellt. Allen gemein ist, dass das Durchlassventil 250 zumindest ein Verstellelement 254 aufweist, welches mittels einer Betätigungskraft FB verschiedene räumliche Positionen einnehmen kann. Dabei nimmt es zumindest in der ersten Betätigungsstellung I eine räumliche Position innerhalb des Durchflussventiles 250 ein, bei welcher eine Öffnung 251 innerhalb des jeweiligen Nebenanschlusses 241, 242 zur Ermöglichung eines Volumenstromes des Kühlmediums 310 bestehen bleibt. Dagegen ist in der zweiten Betätigungsstellung II die Öffnung durch das Verstellelement 254 versperrt, d.h. vollständig mediendicht verschlossen. In der Fig. 3a ist ein schematisches Prinzipbeispiel gezeigt, bei welchem die erste und zweite Betätigungsstellung I, II durch eine Federkraft FF einer Feder 252a bestimmt ist. Wirkt in einer Grundstellung allein die Federkraft FF als Betätigungskraft FB auf das verschiebbare Verstellelement 254, stellt sich beispielsweise die zweite Bestätigungsstellung II ein. Wirkt entgegen der Federkraft FF eine weitere größere Bestätigungskraft FB auf das Verstellelement 254 ein, bewegt sich dieses in die erste Betätigungsstellung I. Eine solche Gegenkraft zur Federkraft FF wird beispielsweise durch einen Anschlussbereich 141, 142 einer externen Kühlvorrichtung 140 in der Funktion eines Betätigungselementes erzeugt, welches durch eine Fügebewegung W bei der Verbindung mit einem Nebenanschluss 241, 242 von außen auf das Verstellelement 254 einwirkt. In der Fig. 3b ist eine ähnliche Ausführung gezeigt, wobei anstelle der Feder 252a ein Magnet 252b eingesetzt ist. Dabei wird die Grundstellung allein durch das Einwirken der Magnetkraft FM auf das Verstellelement 254 bewirkt. Die Gegenkraft kann wiederum vergleichbar wie in Fig. 3a durch das Anschlusselement 241, 242 der externen Kühlvorrichtung 140 das Verstellelement 254 dann in die andere Betätigungsstellung positionieren. Die Fig. 3c zeigt eine weitere Ausführung, bei welcher die Positionierung des Verstellelementes 254 in beide Betätigungsstellungen I, II durch eine elektrische Kraft FE als Betätigungskraft FB erwirkt wird. Die elektrische Kraft FE wird dabei durch eine im Durchflussventil 250 angeordnete elektrische Spule 152c erzeugt, welche stromabhängig eine auf das Verstellelement 254 gerichtete Kraftkomponente FE erwirkt. Dabei kann in Verbindung mit dem Anschlussbereich 141, 142 der externen Kühlvorrichtung 140 eine Schaltbedingung für die elektrische Spule 252c gegeben sein, beispielsweise durch einen elektrischen Kontakt, um die Freigabe für die Betätigungsstellung I zu erwirken. Allgemein können die Betätigungsstellungen I, II auch gerade verdreht ausgeführt sein, als zuvor beschrieben.

Grundsätzlich ergibt sich die Betätigungsstellung demnach bevorzugt in Abhängigkeit eines Verbindungszustandes des Kühlsystems 200 mit einer externen Kühlvorrichtung 140, insbesondere als Teil eines Elektronikmodules 100. Zumindest eine der Betätigungsstellungen I, II ergibt sich insbesondere durch das Einwirken eines Betätigungselementes 141, 142 als Teil einer verbundenen externen Kühlvorrichtung 140 und weiter bevorzugt ergibt sich dann zusätzlich die andere Betätigungsstellung I, II durch das Fehlen der Einwirkung des genannten Betätigungselementes 141, 142. Insgesamt ist dadurch bevorzugt eine gemeinsame Medienkupplung 360 ausgebildet, insbesondere als Verschlusskupplung. Dabei bilden der Anschlussbereich eines Nebenanschlusses 241, 242 und der entsprechende Anschlussbereich 141, 142 der externen Kühlvorrichtung 140 jeweils komplementäre Elemente 361, 362 der Medienkupplung 360, wobei in einer gekuppelten Verbindung die erste Bestätigungsstellung I und bei einer gelösten Verbindung die zweite Betätigungsstellung II eingenommen ist. Hierbei können der Moduleinlass und Modulauslass 141, 142 der externen Kühlvorrichtung 140 in ähnlicher Weise wie die Nebenanschlüsse 241, 242 jeweils ein Durchflussventil 150 aufweisen und/oder ein in mehreren räumlichen Positionen anordbares eigenes Verstellelement 154.

Die Ausführungen können mit umfassen, dass zumindest eines der genannten Verstellelemente 154, 254 in ihrer räumlichen Positionierung zusätzlich steueroder regelbar ist, um den Volumenstrom des Kühlmediums 310 für eine angeschlossene Kühlvorrichtung 140, insbesondere als Teil eines Elektronikmoduls 100, definiert, insbesondere bedarfsgerecht einzustellen. Zum Beispiel kann hierfür die bereits genannte Spule 152c eingesetzt sein. Prinzipiell kann diese auch auf ein anderes weiteres Verstellelement als den Gezeigten erfolgen. Hierfür weist ein angeschlossenes Elektronikmodul 100 beispielsweise eine Steuer- bzw. Regelelektronik auf. Diese umfasst dabei auch einen Temperatursensor, welcher beispielsweise auf einer Leiterplatte in einem temperaturidentifizierenden Bereich angeordnet ist. Dabei generiert die Steuer- bzw. Regelelektronik in Abhängigkeit eines erfassten Temperaturwertes eine Steuer- bzw. Regelgröße, durch welche eine Stellung des Verstellelementes 154, 254 zwischen den Betätigungsstellung I und II einstellbar ist, insbesondere zum Betrieb des Elektronikmodules 100 innerhalb eines definierten Betriebstemperaturbereiches. Alternativ kann das jeweilige Elektronikmodul 100 über einen Außenanschluss bzw. dem Steckverbinder 120 mit einem dem Elektronikmodul 100 übergeordneten Steuer- oder Regelsystem 350 verbunden sein, welches die Steuerung bzw. Regelung des Verstellelementes 154, 254 übernimmt bzw. die Generierung der Steuer- bzw. der Regelgröße bewirkt. Hierfür können die elektrisch regelbaren Verstellelemente 254 des Grundkühlmodules 200' ebenfalls über das Bussystem 355 mit dem Steuer- oder Regelsystem 350 verbunden sein.

Das Grundkühlmodul 200' ist zur flexiblen Erweiterung des Basiskühlkanalsystems 220 modular aus mindestens zwei oder mehreren Einzelmodulelementen 210.1, 210.2, 210.3, 210.x ausgebildet. Dabei umfasst jedes Einzelmodulelement 210.1, 210.2, 210.3, 210.x jeweils zumindest einen Teilabschnitt 225.a, 225.b, 225.c, 225.x des zumindest einen Kühlkanalstrangs 225. In einem insbesondere lösbaren Verbindungsbereich V zweier unmittelbar angrenzenden Einzelmodulelemente 210.1, 210.2, 210.3, 210.x schließen sich deren jeweils umfasste zumindest ein Teilabschnitt 225.a, 225.b, 225.c, 225.x fortlaufend zu dem zumindest einen Kühlkanalstrang 225 an. Damit die Einzelmodulelemente 210.1, 210.2, 210.3, 210.x im Verbund unter Ausbildung des Grundkühlmoduls 200' mechanisch festgehalten werden, sind diese mittels eines insbesondere lösbaren Verbindungssystems 270 kraft- und/oder formschlüssig miteinander verbunden. Als Möglichkeit bietet sich beispielsweise eine Schraubverbindung an, insbesondere umfassend zumindest eine Gewindestange 271, welche alle festzuhaltenden Einzelmodulelemente 210.1, 210.2, 210.3, 210.x durch eine Befestigungsöffnung 215 hindurch durchdringt. Mittels Kontermuttern in den Endbereichen der Gewindestange 271 werden die dazwischen angeordneten Einzelmodulelemente 210.1, 210.2, 210.3, 210.x gegeneinander verspannt und fixiert. Alternativ können die Einzelmodulelemente 210.1, 210.2, 210.3, 210.x auch durch eine jeweilige Rastverbindung, Steckverbindung oder einen Bügelverschluss im Verbindungsbereich befestigt sein (nicht dargestellt). Ebenso wird das Elektronikmodul 100 zusätzlich mit zumindest einem Einzelmodulelement 210.1, 210.2, 210.3, 210.x befestigt. Hierfür weisen das Elektronikmodul 100 und das zumindest eine Einzelmodulelement 210.1, 210.2, 210.3, 210.x jeweils komplementäre Elemente 371, 372 eines gemeinsamen, insbesondere lösbaren Befestigungssystems 370 auf, welche zusammen in Wirkzusammenhang gebracht werden. Das Befestigungssystem 370 ist beispielsweise eine Schraubverbindung, eine Rastverbindung, eine Steckverbindung oder ein Bügelverschluss.

In dem jeweiligen Verbindungsbereich V sind die direkt fortlaufend anschließenden Teilabschnitte 225.a, 225.b, 225.c, 225.x zueinander abgedichtet. Auf diese Weise wird ein Kühlmediumverlust im Verbund der Einzelmodulelemente 210.1, 210.2, 210.3, 210.x verhindert.

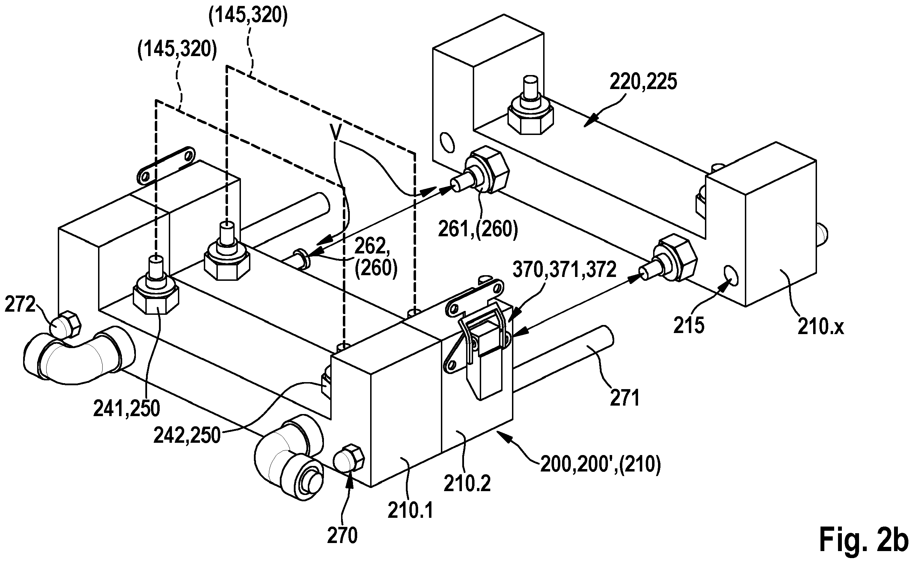

Die Fig. 2b zeigt zwei Einzelmodulelemente 210.1, 210.2, 210.3, 210.x in einer gelösten perspektivischen Darstellung. Grundsätzlich weisen zwei unmittelbar benachbarte Einzelmodulelemente 210.1, 210.2, 210.3, 210.x im Verbindungsbereich V jeweils ein komplementäres Element 261, 262 einer gemeinsamen Medienkupplung 260 auf, insbesondere als Verschlusskupplung. Dabei ist in einer gelösten Verbindung zwischen beiden benachbarten Einzelmodulelementen 210.1, 210.2, 210.3, 210.x der jeweilige in einem Einzelmodulelement 210.1, 210.2, 210.3, 210.x enthaltene Teilabschnitt 225.a, 225.b, 225.c, 225.x zumindest in dessen Verbindungsbereich V mediendicht verschlossen. In einer gekuppelten Verbindung zwischen beiden benachbarten Einzelmodulelementen 210.1, 210.2, 210.3, 210.x ist dagegen im Verbindungsbereich V ein Durchgang für einen Kühlmediumfluss innerhalb der Medienkupplung 260 geöffnet. Die Ausführung der Medienkupplung 260 kann hierbei der Medienkupplung 360 entsprechen, wie sie in den Fig. 3a - 3b im Zusammenhang mit dem Anschlussbereich eines Nebenanschlusses 241, 242 und dem entsprechende Anschlussbereich 141, 142 der externen Kühlvorrichtung 140 zuvor beschrieben ist.

In der Fig. 2c ist noch eine mögliche Ausführung eines Einzelmodulelementes 210.1, 210.2, 210.3, 210.x gezeigt, in welchem ein Überbrückungskühlkanalstrang 230 ausgebildet ist, welcher zwei umfasste Teilabschnitte 225.a, 225.b, 225.c, 225.x im Bereich von zwei ebenfalls umfassten Nebenanschlüssen 241, 242 miteinander verbindet. Damit ist ein Querfluss Q des Kühlmediums 310 innerhalb des Überbrückungskühlkanalstrangs 230 ermöglicht. Ferner ist zwischen den beiden Nebenanschlüssen 241, 242 mindestens ein weiterer Nebenanschluss 243 oder weitere (nicht dargestellt) angeordnet, welcher einen direkten Medienzugang zum Überbrückungskühlkanalstrang 230 aufweist/aufwiesen. Dabei besteht neben einer ersten Anschlussmöglichkeit A1 einer externen Kühlvorrichtung 140 als paralleler Nebenstrang einer Kühlstrecke 145 wie in den bisher gezeigten Ausführungen zusätzlich auch eine zweite und dritte Anschlussmöglichkeit A2, A3, bei weiteren Nebenanschlüssen noch weitere. Hierbei können die Anschlussmöglichkeiten A1, A2, A3 unterschiedliche Anschlussmaße zum Anschluss der externen Kühlvorrichtung 140 bereithalten.

## Patentansprüche

1. Kühlsystem (200) mit einem geschlossenen Kühlkanalsystem, welches zwischen einem Haupteinlass und einem Hauptauslass (211, 212) für ein Kühlmedium (310) ausgebildet ist und zumindest einen Kühlkanalstrang (225) umfasst, wobei das Kühlsystem (200) aus zwei oder mehreren benachbarten Einzelmodulelementen (210.1, 210.2 210.3, 210.x) gebildet und dabei jedes Einzelmodulelement (210.1, 210.2, 210.3, 210.x) jeweils zumindest einen Teilabschnitt (225.a, 225.b, 225.c, 225.x) des zumindest einen Kühlkanalstrangs (225) umfasst, und wobei in einem insbesondere lösbaren Verbindungsbereich (V) beider Einzelmodulelemente (210.1, 210.2, 210.3, 210.x) zueinander deren jeweils umfasste zumindest eine Teilabschnitt (225.a, 225.b, 225.c, 225.x) sich fortlaufend zu dem zumindest einen Kühlkanalstrang (225) anschließen, wobei die benachbarten Einzelmodulelemente (210.1, 210.2, 210.3, 210.x) im Verbindungsbereich (V) jeweils ein komplementäres Elemente (361, 362) einer gemeinsamen Medienkupplung (360) aufweisen, insbesondere als Verschlusskupplung, bei welcher in einer gelösten Verbindung zwischen beiden benachbarten Einzelmodulelementen (210.1, 210.2, 210.3, 210.x) der jeweilige in einem Einzelmodulelement (210.1, 210.2, 210.3, 210.x) enthaltene Teilabschnitt (225.a, 225.b, 225.c, 225.x) zumindest in dessen Verbindungsbereich (V) mediendicht verschlossen ist und in einer gekuppelten Verbindung zwischen beiden benachbarten Einzelmodulelementen (210.1, 210.2, 210.3, 210.x) im Verbindungsbereich (V) ein Durchgang für einen Kühlmediumfluss innerhalb der Medienkupplung (360) geöffnet ist,
**dadurch gekennzeichnet, dass**
das Kühlsystem (200) als ein Grundkühlmodul (200`) ausgebildet ist, welches den zumindest einen Kühlkanalstrang (225) als ein Basiskühlkanalsystem (220) umfasst, wobei das Basiskühlkanalsystem (220) mindestens zwei Nebenanschlüsse (241, 242) aufweist mittels welchen das Basiskühlkanalsystem (220) außerhalb des Grundkühlmodules (200') durch eine lösbare Verbindung mit zumindest einer Kühlstrecke (145) einer externen Kühlvorrichtung (140) erweiterbar ist, dass die mindestens zwei Nebenanschlüsse (241, 242) jeweils ein Durchflussventil (250) für das Kühlmedium (310) umfassen, wobei das Durchflussventil (310) ausgebildet ist, in einer ersten Betätigungsstellung (I) das Basiskühlkanalsystem (220) für einen Kühlmediumfluss zu öffnen und in einer zweiten Betätigungsstellung (II) das Basiskühlkanalsystem (220) mediendicht zu verschließen, **dass** die Durchflussventile (250) der Nebenanschlüsse (241, 242) jeweils einen Anschlussbereich aufweisen zur insbesondere lösbaren Verbindung des Basiskühlkanalsystems (220) an eine Kühlstrecke (145) einer externen Kühlvorrichtung (140), wobei der jeweilige Anschlussbereich als komplementäres Element (361, 362) einer gemeinsamen Medienkupplung (360) mit der externen Kühlvorrichtung (140) ausgebildet ist, insbesondere als Verschlusskupplung, bei welcher in einer gekuppelten Verbindung zwischen dem Grundkühlmodul (200`) und der externen Kühlvorrichtung (140) die erste Betätigungsstellung (I) einnehmbar ist und in einer gelösten Verbindung zwischen dem Grundkühlmodul (200`) und der Kühlvorrichtung (140) die zweite Betätigungsstellung (II) einnehmbar ist, wobei die erste und die zweite Betätigungsstellung (I, II) durch eine Federkraft (FF), eine Magnetkraft (FM) oder eine elektrische Kraft (FE) bestimmt sind, in Abhängigkeit eines Kupplungszustandes mit dem komplementären Element (361, 362) einer externen Kühlvorrichtung (140).

2. Kühlsystem (200) nach Anspruch 1,
**dadurch gekennzeichnet, dass**
das zumindest ein Paar von Nebenanschlüssen (241, 242) genau einem oder zumindest einem durchgehenden Kühlkanalstrang (225) des Basiskühlkanalsystems (220) und/oder zumindest ein Paar von Nebenanschlüssen (241, 242) genau zwei oder mindestens zwei voneinander getrennten Kühlkanalsträngen (225) zugeordnet sind, so dass die Kühlstrecke (145) mindestens einer externen Kühlvorrichtung (140) als paralleler Nebenstrang an dem jeweils zumindest einen zugeordneten Kühlkanalstrang (225) anschließbar ist und/oder die zumindest beiden zugeordneten voneinander getrennten Kühlkanalsträngen (225) durch die Kühlstrecke (145) überbrückend miteinander verbindbar sind.

3. Kühlsystem (200) nach Anspruch 1 oder 2,
**dadurch gekennzeichnet, dass**
das Basiskühlkanalsystem (220) genau einen oder zumindest einen Kühlkanalstrang (225) umfasst, welcher u-förmig innerhalb des Kühlsystems (200) ausgebildet ist, wobei der Haupteinlass und der Hauptauslass (211, 212) auf der gleichen Seite des Kühlsystems (200) in den Endbereichen des Kühlkanalstranges (225) angeordnet sind.

4. Kühlsystem (200) nach Anspruch 1 oder 2,
**dadurch gekennzeichnet, dass**
das Basiskühlkanalsystem (220) zwei voneinander getrennten Kühlkanalstränge (225) umfasst, welche parallel zueinander innerhalb des Kühlsystems (200) ausgebildet sind, wobei der Haupteinlass und der Hauptauslass (211, 212) bevorzugt jeweils in einem Endbereich der voneinander getrennten Kühlkanalstränge (225) angeordnet sind, und wobei der Haupteinlass und der Hauptauslass (211, 212) auf der gleichen Seite des Kühlsystems (200) oder auf gegenüberliegenden Seiten des Kühlsystems (200) angeordnet sind.

5. Kühlsystem (200) nach einem der Ansprüche 1 bis 4,
**dadurch gekennzeichnet, dass**
zumindest ein oder alle Einzelmodulelemente (210.1, 210.2, 210.3, 210.x) genau zwei Nebenanschlüsse (241, 242) aufweist/aufweisen.

6. Kühlsystem (200) nach einem der Ansprüche 1 bis 5,
**dadurch gekennzeichnet, dass**
in zumindest einem oder in allen Einzelmodulelementen (210.1, 210.2, 210.3, 210.x) jeweils ein Überbrückungskühlkanalstrang (230) ausgebildet ist, welcher innerhalb des Einzelmodulelementes (210.1, 210.2, 210.3, 210.x) in zwei umfasste Teilabschnitte (225.a, 225.b, 225.c, 225.x) des zumindest einen Kühlkanalstrangs (225) des Basiskühlkanalsystems (220) mündet, wobei das Einzelmodulelement (210.1, 210.2, 210.3, 210.x) mindestens drei Nebenanschlüsse (241, 242) aufweist, von denen jeweils zwei mit einem Moduleinlass und einem Modulauslass (141, 142) einer externen Kühlvorrichtung (140) verbindbar sind, so dass die Kühlstrecke (145) der externen Kühlvorrichtung (145) als paralleler Nebenstrang zu einem zwischen den verbindbaren Nebenanschlüssen (241, 242) ausgebildeten Teilabschnitt des Überbrückungskühlkanalstrangs (230) anschließbar ist.

7. Kühlsystem (200) nach einem der Ansprüche 1 bis 6,
**dadurch gekennzeichnet, dass**
zur Erwirkung eines mechanisch gehaltenen Verbundkörpers die Einzelmodulelemente (210.1, 210.2, 210.3, 210.x) kraft- und/oder formschlüssig miteinander verbunden sind.

8. Kühlsystem (200) nach einem der Ansprüche 1 bis 7,
**dadurch gekennzeichnet, dass**
das Grundkühlmodul (200`) zumindest ein Befestigungselement aufweist, welches als komplementäres Element (371, 372) eines lösbaren gemeinsamen Befestigungssystems (370) mit einer externen Kühlvorrichtung (140) zur deren gemeinsamen ausschließlich mechanischen Befestigung zueinander ausgebildet ist, wobei das Befestigungssystem (370) bevorzugt als Schraubverbindung, als Rastverbindung, als Steckverbindung oder als Bügelverschluss ausgelegt ist.

9. Kühlsystem (200) nach Anspruch 1,
**dadurch gekennzeichnet, dass**
die Nebenanschlüsse (241, 242) jeweils ein steuerbares oder regelbares, insbesondere elektrisch steuerbares oder regelbares, Durchflussventil (250) zur Einstellung eines Volumenstromes des Kühlmediums (310) aufweisen.

10. Einzelmodulelement (210.1, 210.2, 210.3, 210.x) eines Kühlsystems (200) nach
einem der vorhergehenden Ansprüche, wobei das Kühlsystem (200) aus zwei oder mehreren benachbarten Einzelmodulelementen (210.1, 210.2,210.3, 210.x) gebildet und dabei jedes Einzelmodulelement (210.1, 210.2, 210.3, 210.x) jeweils zumindest einen Teilabschnitt (225.a, 225.b, 225.c, 225.x) des zumindest einen Kühlkanalstrangs (225) umfasst, und wobei in einem insbesondere lösbaren Verbindungsbereich (V) beider Einzelmodulelemente (210.1, 210.2, 210.3, 210.x) zueinander deren jeweils umfasste zumindest eine Teilabschnitt (225.a, 225.b, 225.c, 225.x) sich fortlaufend zu dem zumindest einen Kühlkanalstrang (225) anschließen, wobei die benachbarten Einzelmodulelemente (210.1, 210.2, 210.3, 210.x) im Verbindungsbereich (V) jeweils ein komplementäres Elemente (361, 362) einer gemeinsamen Medienkupplung (360) aufweisen, insbesondere als Verschlusskupplung, bei welcher in einer gelösten Verbindung zwischen beiden benachbarten Einzelmodulelementen (210.1, 210.2, 210.3, 210.x) der jeweilige in einem Einzelmodulelement (210.1, 210.2, 210.3, 210.x) enthaltene Teilabschnitt (225.a, 225.b, 225.c, 225.x) zumindest in dessen Verbindungsbereich (V) mediendicht verschlossen ist und in einer gekuppelten Verbindung zwischen beiden benachbarten Einzelmodulelementen (210.1, 210.2, 210.3, 210.x) im Verbindungsbereich (V) ein Durchgang für einen Kühlmediumfluss innerhalb der Medienkupplung (360) geöffnet ist, **dadurch gekennzeichnet, dass** das Kühlsystem (200) als ein Grundkühlmodul (200') ausgebildet ist, welches den zumindest einen Kühlkanalstrang (225) als ein Basiskühlkanalsystem (220) umfasst, wobei das Basiskühlkanalsystem (220) mindestens zwei Nebenanschlüsse (241, 242) aufweist mittels welchen das Basiskühlkanalsystem (220) außerhalb des Grundkühlmodules (200') durch eine lösbare Verbindung mit zumindest einer Kühlstrecke (145) einer externen Kühlvorrichtung (140) erweiterbar ist, dass die mindestens zwei Nebenanschlüsse (241, 242) jeweils ein Durchflussventil (250) für das Kühlmedium (310) umfassen, wobei das Durchflussventil (310) ausgebildet ist, in einer ersten Betätigungsstellung (I) das Basiskühlkanalsystem (220) für einen Kühlmediumfluss zu öffnen und in einer zweiten Betätigungsstellung (II) das Basiskühlkanalsystem (220) mediendicht zu verschließen, dass die Durchflussventile (250) der Nebenanschlüsse (241, 242) jeweils einen Anschlussbereich aufweisen zur insbesondere lösbaren Verbindung des Basiskühlkanalsystems (220) an eine Kühlstrecke (145) einer externen Kühlvorrichtung (140), wobei der jeweilige Anschlussbereich als komplementäres Element (361, 362) einer gemeinsamen Medienkupplung (360) mit der externen Kühlvorrichtung (140) ausgebildet ist, insbesondere als Verschlusskupplung, bei welcher in einer gekuppelten Verbindung zwischen dem Grundkühlmodul (200') und der externen Kühlvorrichtung (140) die erste Betätigungsstellung (I) einnehmbar ist und in einer gelösten Verbindung zwischen dem Grundkühlmodul (200') und der Kühlvorrichtung (140) die zweite Betätigungsstellung (II) einnehmbar ist, wobei die erste und die zweite Betätigungsstellung (I, II) durch eine Federkraft (FF), eine Magnetkraft (FM) oder eine elektrische Kraft (FE) bestimmt sind, in Abhängigkeit eines Kupplungszustandes mit dem komplementären Element (361, 362) einer externen Kühlvorrichtung (140).

11. Kühlanordnung (300`) umfassend zumindest ein Kühlsystem (200) nach einem der Ansprüche, 1 bis 9, wobei zumindest zwei Nebenanschlüsse (241, 242) mit einer Kühlstrecke (145) einer externen Kühlvorrichtung (140) verbunden sind.

## Claims

1. Cooling system (200) having a closed cooling-channel system which is formed between a main inlet and a main outlet (211, 212) for a cooling medium (310) and comprises at least one cooling-channel section (225), wherein the cooling system (200) is formed from two or more adjacent single-module elements (210.1, 210.2, 210.3, 210.x) and each single-module element (210.1, 210.2, 210.3, 210.x) comprises in each case at least one sub-portion (225.a, 225.b, 225.c, 225.x) of the at least one cooling-channel section (225), and wherein, in an in particular releasable connecting region (V) of two single-module elements (210.1, 210.2, 210.3, 210.x) with respect to one another, their respective comprised at least one sub-portions (225.a, 225.b, 225.c, 225.x) adjoin in a progressive manner with respect to the at least one cooling-channel section (225), wherein the adjacent single-module elements (210.1, 210.2, 210.3, 210.x) have in the connecting region (V) in each case one complementary element (361, 362) of a common media coupling (360), in particular in the form of a closure coupling, in the case of which, with a released connection between two adjacent single-module elements (210.1, 210.2, 210.3, 210.x), the respective sub-portion (225.a, 225.b, 225.c, 225.x) contained in a single-module element (210.1, 210.2, 210.3, 210.x), at least in its connecting region (V), is closed off in a media-tight manner and, with a coupled connection between two adjacent single-module elements (210.1, 210.2, 210.3, 210.x), a passage for a cooling-medium flow within the media coupling (360) is open in the connecting region (V),
**characterized in that** the
cooling system (200) is in the form of a main cooling module (200') which comprises the at least one cooling-channel section (225) as a base cooling-channel system (220), wherein the base cooling-channel system (220) has at least two auxiliary connections (241, 242) by means of which the base cooling-channel system (220) is able to be extended beyond the main cooling module (200') by way of a releasable connection to at least one cooling path (145) of an external cooling device (140), **in that** the at least two auxiliary connections (241, 242) comprise in each case one throughflow valve (250) for the cooling medium (310), wherein the throughflow valve (310) is configured such that, in a first actuation position (I), it opens the base cooling-channel system (220) for a cooling-medium flow and, in a second actuation position (II),
it closes off the base cooling-channel system (220) in a media-tight manner, **in that** the throughflow valves (250) of the auxiliary connections (241, 242) have in each case one connection region for in particular releasable connection of the base cooling-channel system (220) to a cooling path (145) of an external cooling device (140), wherein the respective connection region is in the form of a complementary element (361, 362) of a common media coupling (360) with respect to the external cooling device (140), in particular in the form of a closure coupling, in the case of which, with a coupled connection between the main cooling module (200') and the external cooling device (140), the first actuation position (I) is able to be assumed and, with a released connection between the main cooling module (200') and the cooling device (140), the second actuation position (II) is able to be assumed, wherein the first and second actuation positions (I, II) are determined by a spring force (FF), a magnetic force (FM) or an electrical force (FE) in a manner dependent on a coupling state with respect to the complementary element (361, 362) of an external cooling device (140).

2. Cooling system (200) according to Claim 1,
**characterized in that**
the at least one pair of auxiliary connections (241, 242) is assigned to exactly one or at least one continuous cooling-channel section (225) of the base cooling-channel system (220) and/or at least one pair of auxiliary connections (241, 242) is assigned to exactly two or at least two mutually separated cooling-channel sections (225), such that the cooling path (145) of at least one external cooling device (140) is connectable as a parallel adjacent section to the in each case at least one assigned cooling-channel section (225) and/or the at least two assigned mutually separated cooling-channel sections (225) are connectable to one another in a bypassing manner by the cooling path (145).

3. Cooling system (200) according to Claim 1 or 2, **characterized in that**
the base cooling-channel system (220) comprises exactly one or at least one cooling-channel section (225) which is formed in the shape of a U within the cooling system (200), wherein the main inlet and the main outlet (211, 212) are arranged in the end regions of the cooling-channel section (225) on the same side of the cooling system (200).

4. Cooling system (200) according to Claim 1 or 2, **characterized in that**
the base cooling-channel system (220) comprises two mutually separated cooling-channel sections (225) which are formed parallel to one another within the cooling system (200), wherein the main inlet and the main outlet (211, 212) are preferably each arranged in an end region of the mutually separated cooling-channel sections (225), and wherein the main inlet and the main outlet (211, 212) are arranged on the same side of the cooling system (200) or on opposite sides of the cooling system (200).

5. Cooling system (200) according to one of Claims 1 to 4,
**characterized in that**
at least one or all of the single-module elements (210.1, 210.2, 210.3, 210.x) has/have exactly two auxiliary connections (241, 242).

6. Cooling system (200) according to one of Claims 1 to 5,
**characterized in that**
in at least one or in all of the single-module elements (210.1, 210.2, 210.3, 210.x), there is formed in each case one bypass cooling-channel section (230) which opens out within the single-module element (210.1, 210.2, 210.3, 210.x) into two comprised sub-portions (225.a, 225.b, 225.c, 225.x) of the at least one cooling-channel section (225) of the base cooling-channel system (220), wherein the single-module element (210.1, 210.2, 210.3, 210.x) has at least three auxiliary connections (241, 242), of which in each case two are connectable to a module inlet and a module outlet (141, 142) of an external cooling device (140) such that the cooling path (145) of the external cooling device (145) is connectable as a parallel adjacent section in relation to a sub-portion of the bypass cooling-channel section (230) that is formed between the connectable auxiliary connections (241, 242).

7. Cooling system (200) according to one of Claims 1 to 6,
**characterized in that**
to achieve a mechanically retained composite body, the single-module elements (210.1, 210.2, 210.3, 210.x) are connected to one another in a force-fitting and/or formfitting manner.

8. Cooling system (200) according to one of Claims 1 to 7,
**characterized in that**
the main cooling module (200') has at least one fastening element which is in the form of a complementary element (371, 372) of a releasable common fastening system (370) with respect to an external cooling device (140) for the common, exclusively mechanical fastening thereof to one another, wherein the fastening system (370) is preferably designed in the form of a screw connection, in the form of a latching connection, in the form of a plug connection or in the form of a clip lock.

9. Cooling system (200) according to Claim 1,
**characterized in that**
the auxiliary connections (241, 242) have in each case one controllable or regulable, in particular electrically controllable or regulable, throughflow valve (250) for setting a volume flow of the cooling medium (310).

10. Single-module element (210.1, 210.2, 210.3, 210.x) of a cooling system (200) according to one of the preceding claims, wherein the cooling system (200) is formed from two or more adjacent single-module elements (210.1, 210.2, 210.3, 210.x) and each single-module element (210.1, 210.2, 210.3, 210.x) comprises in each case at least one sub-portion (225.a, 225.b, 225.c, 225.x) of the at least one cooling-channel section (225), and wherein, in an in particular releasable connecting region (V) of two single-module elements (210.1, 210.2, 210.3, 210.x) with respect to one another, their respective comprised at least one sub-portions (225.a, 225.b, 225.c, 225.x) adjoin in a progressive manner with respect to the at least one cooling-channel section (225), wherein the adjacent single-module elements (210.1, 210.2, 210.3, 210.x) have in the connecting region (V) in each case one complementary element (361, 362) of a common media coupling (360), in particular in the form of a closure coupling, in the case of which, with a released connection between two adjacent single-module elements (210.1, 210.2, 210.3, 210.x), the respective sub-portion (225.a, 225.b, 225.c, 225.x) contained in a single-module element (210.1, 210.2, 210.3, 210.x), at least in its connecting region (V), is closed off in a media-tight manner and, with a coupled connection between two adjacent single-module elements (210.1, 210.2, 210.3, 210.x), a passage for a cooling-medium flow within the media coupling (360) is open in the connecting region (V), **characterized in that** the cooling system (200) is in the form of a main cooling module (200') which comprises the at least one cooling-channel section (225) as a base cooling-channel system (220), wherein the base cooling-channel system (220) has at least two auxiliary connections (241, 242) by means of which the base cooling-channel system (220) is able to be extended beyond the main cooling module (200') by way of a releasable connection to at least one cooling path (145) of an external cooling device (140), **in that** the at least two auxiliary connections (241, 242) comprise in each case one throughflow valve (250) for the cooling medium (310), wherein the throughflow valve (310) is configured such that, in a first actuation position (I), it opens the base cooling-channel system (220) for a cooling-medium flow and, in a second actuation position (II), it closes off the base cooling-channel system (220) in a media-tight manner, **in that** the throughflow valves (250) of the auxiliary connections (241, 242) have in each case one connection region for in particular releasable connection of the base cooling-channel system (220) to a cooling path (145) of an external cooling device (140), wherein the respective connection region is in the form of a complementary element (361, 362) of a common media coupling (360) with respect to the external cooling device (140), in particular in the form of a closure coupling, in the case of which, with a coupled connection between the main cooling module (200') and the external cooling device (140), the first actuation position (I) is able to be assumed and, with a released connection between the main cooling module (200') and the cooling device (140), the second actuation position (II) is able to be assumed, wherein the first and second actuation positions (I, II) are determined by a spring force (FF), a magnetic force (FM) or an electrical force (FE) in a manner dependent on a coupling state with respect to the complementary element (361, 362) of an external cooling device (140).

11. Cooling arrangement (300') comprising at least one cooling system (200) according to one of Claims 1 to 9, wherein at least two auxiliary connections (241, 242) are connected to a cooling path (145) of an external cooling device (140).

## Revendications

1. Système de refroidissement (200) avec un système de canal de refroidissement fermé, qui est réalisé entre une entrée principale et une sortie principale (211, 212) pour un fluide de refroidissement (310) et qui comprend au moins une ligne de canal de refroidissement (225), le système de refroidissement (200) étant formé de deux éléments modulaires individuels voisins ou plus (210.1, 210.2,
210.3, 210.x) et chaque élément modulaire individuel (210.1, 210.2, 210.3, 210.x) comprenant respectivement au moins une section partielle (225.a, 225.b, 225.c, 225.x) de l'au moins une ligne de canal de refroidissement (225) et, dans une zone de liaison (V) notamment détachable des deux éléments modulaires individuels (210.1, 210.2, 210.3, 210.x) l'un par rapport à l'autre, leur au moins une section partielle (225.a, 225.b, 225.c, 225.x) respectivement comprise se raccordant en continu à l'au moins une ligne de canal de refroidissement (225), les éléments modulaires individuels voisins (210.1, 210.2, 210.3, 210.x) présentant respectivement, dans la zone de liaison (V), un élément complémentaire (361, 362) d'un accouplement de fluide commun (360), notamment sous forme d'accouplement de fermeture, dans lequel, dans une liaison détachée entre les deux éléments modulaires individuels voisins (210.1, 210.2, 210.3, 210.x), la section partielle respective (225.a, 225.b, 225.c, 225.x) contenue dans un élément modulaire individuel (210.1, 210.2, 210.3, 210.x) est fermée de manière étanche au fluide au moins dans sa zone de liaison (V) et, dans une liaison accouplée entre les deux éléments modulaires individuels voisins (210.1, 210.2, 210.3, 210.x), un passage pour un flux de fluide de refroidissement est ouvert dans la zone de liaison (V) à l'intérieur de l'accouplement de fluide (360),
**caractérisé en ce que**
le système de refroidissement (200) est réalisé sous la forme d'un module de refroidissement de base (200') qui comprend l'au moins une ligne de canal de refroidissement (225) sous la forme d'un système de canal de refroidissement de base (220), le système de canal de refroidissement de base (220) présentant au moins deux raccords secondaires (241, 242) au moyen desquels le système de canal de refroidissement de base (220) peut être étendu à l'extérieur du module de refroidissement de base (200') par une liaison détachable avec au moins un tronçon de refroidissement (145) d'un dispositif de refroidissement externe (140), **en ce que** les au moins deux raccords secondaires (241, 242) comprennent respectivement une soupape de passage (250) pour le fluide de refroidissement (310), la soupape de passage (310) étant réalisée pour, dans une première position d'actionnement (I), ouvrir le système de canal de refroidissement de base (220) pour un flux de fluide de refroidissement et, dans une deuxième position d'actionnement (II),
fermer de manière étanche au fluide le système de canal de refroidissement de base (220), **en ce que** les soupapes de passage (250) des raccords secondaires (241, 242) présentent respectivement une zone de raccordement pour la liaison, notamment détachable, du système de canal de refroidissement de base (220) à un tronçon de refroidissement (145) d'un dispositif de refroidissement externe (140), la zone de raccordement respective étant réalisée sous forme d'élément complémentaire (361, 362) d'un accouplement de fluide (360) commun avec le dispositif de refroidissement externe (140), notamment sous forme d'accouplement de fermeture, dans lequel, dans une liaison accouplée entre le module de refroidissement de base (200') et le dispositif de refroidissement externe (140), la première position d'actionnement (I) peut être prise et, dans une liaison détachée entre le module de refroidissement de base (200') et le dispositif de refroidissement (140), la deuxième position d'actionnement (II) peut être prise, la première et la deuxième position d'actionnement (I, II) étant déterminées par une force élastique (FF), une force magnétique (FM) ou une force électrique (FE), en fonction d'un état d'accouplement avec l'élément complémentaire (361, 362) d'un dispositif de refroidissement externe (140) .

2. Système de refroidissement (200) selon la revendication 1,
**caractérisé en ce que**
l'au moins une paire de raccords secondaires (241, 242) est associée exactement à une ou au moins une ligne de canal de refroidissement (225) continue du système de canal de refroidissement de base (220) et/ou au moins une paire de raccords secondaires (241, 242) est associée exactement à deux ou au moins deux lignes de canal de refroidissement (225) séparées l'une de l'autre, de telle sorte que le tronçon de refroidissement (145) d'au moins un dispositif de refroidissement externe (140) peut être raccordé en tant que ligne secondaire parallèle à l'au moins une ligne de canal de refroidissement (225) associée respective et/ou les au moins deux lignes de canal de refroidissement (225) associées séparées l'une de l'autre peuvent être reliées entre elles par le tronçon de refroidissement (145) en formant un pont.

3. Système de refroidissement (200) selon la revendication 1 ou 2,
**caractérisé en ce que**
le système de canal de refroidissement de base (220) comprend exactement une ou au moins une ligne de canal de refroidissement (225) qui est réalisée en forme de U à l'intérieur du système de refroidissement (200), l'entrée principale et la sortie principale (211, 212) étant agencées sur le même côté du système de refroidissement (200) dans les zones d'extrémité de la ligne de canal de refroidissement (225).

4. Système de refroidissement (200) selon la revendication 1 ou 2,
**caractérisé en ce que**
le système de canal de refroidissement de base (220) comprend deux lignes de canal de refroidissement séparées l'une de l'autre (225), qui sont réalisées parallèlement l'une à l'autre à l'intérieur du système de refroidissement (200), l'entrée principale et la sortie principale (211, 212) étant de préférence agencées respectivement dans une zone d'extrémité des lignes de canal de refroidissement séparées l'une de l'autre (225), et l'entrée principale et la sortie principale (211, 212) étant agencées sur le même côté du système de refroidissement (200) ou sur des côtés opposés du système de refroidissement (200).

5. Système de refroidissement (200) selon l'une quelconque des revendications 1 à 4,
**caractérisé en ce**
**qu'**au moins un ou tous les éléments modulaires individuels (210.1, 210.2, 210.3, 210.x) présentent exactement deux raccords secondaires (241, 242).

6. Système de refroidissement (200) selon l'une quelconque des revendications 1 à 5,
**caractérisé en ce que**
dans au moins un ou dans tous les éléments modulaires individuels (210.1, 210.2, 210.3, 210.x) est réalisée respectivement une ligne de canal de refroidissement de pontage (230) qui, à l'intérieur de l'élément modulaire individuel (210.1, 210.2, 210.3, 210.x) débouche dans deux sections partielles comprises (225.a, 225.b, 225.c, 225.x) de l'au moins une ligne de canal de refroidissement (225) du système de canal de refroidissement de base (220), l'élément modulaire individuel (210.1, 210.2, 210.3, 210.x) présentant au moins trois raccords secondaires (241, 242), dont deux peuvent être respectivement reliés à une entrée de module et à une sortie de module (141, 142) d'un dispositif de refroidissement externe (140), de telle sorte que le tronçon de refroidissement (145) du dispositif de refroidissement externe (145) peut être raccordé en tant que ligne secondaire parallèle à une section partielle, réalisée entre les raccords secondaires (241, 242) pouvant être reliés, de la ligne de canal de refroidissement de pontage (230).

7. Système de refroidissement (200) selon l'une quelconque des revendications 1 à 6,
**caractérisé en ce que**
pour obtenir un corps composite maintenu mécaniquement, les éléments modulaires individuels (210.1, 210.2, 210.3, 210.x) sont reliés entre eux par force et/ou par complémentarité de forme.

8. Système de refroidissement (200) selon l'une quelconque des revendications 1 à 7,
**caractérisé en ce que**
le module de refroidissement de base (200') présente au moins un élément de fixation qui est réalisé sous forme d'élément complémentaire (371, 372) d'un système de fixation commun amovible (370) avec un dispositif de refroidissement externe (140) pour leur fixation commune exclusivement mécanique l'un par rapport à l'autre, le système de fixation (370) étant conçu de préférence sous forme de liaison par vis, sous forme de liaison par encliquetage, sous forme de liaison par enfichage ou sous forme de fermeture à étrier.

9. Système de refroidissement (200) selon la revendication 1,
**caractérisé en ce que**
les raccords secondaires (241, 242) présentent respectivement une soupape de passage (250) pouvant être commandée ou pouvant être réglée, notamment pouvant être commandée ou pouvant être réglée électriquement, pour ajuster un débit volumétrique du fluide de refroidissement (310).

10. Élément modulaire individuel (210.1, 210.2, 210.3, 210.x) d'un système de refroidissement (200) selon l'une quelconque des revendications précédentes, le système de refroidissement (200) étant formé de deux éléments modulaires individuels voisins ou plus (210.1, 210.2, 210.3, 210.x) et chaque élément modulaire individuel (210.1, 210.2, 210.3, 210.x) comprenant respectivement au moins une section partielle (225.a, 225.b, 225.c, 225.x) de l'au moins une ligne de canal de refroidissement (225) et, dans une zone de liaison (V) notamment détachable des deux éléments modulaires individuels (210.1, 210.2, 210.3, 210.x) l'un par rapport à l'autre, leur au moins une section partielle (225.a, 225.b, 225.c, 225.x) respectivement comprise se raccordant en continu à l'au moins une ligne de canal de refroidissement (225), les éléments modulaires individuels voisins (210.1, 210.2, 210.3, 210.x) présentant dans la zone de liaison (V) respectivement un élément complémentaire (361, 362) d'un accouplement de fluide commun (360), notamment sous forme d'accouplement de fermeture, dans lequel, dans une liaison détachée entre les deux éléments modulaires individuels voisins (210.1, 210.2, 210.3, 210.x), la section partielle respective (225.a, 225.b, 225.c, 225.x) contenue dans un élément modulaire individuel (210.1, 210.2, 210.3, 210.x) est fermée de manière étanche au fluide au moins dans sa zone de liaison (V) et, dans une liaison accouplée entre les deux éléments modulaires individuels voisins (210.1, 210.2, 210.3, 210.x), un passage est ouvert pour un flux de fluide de refroidissement dans la zone de liaison (V) à l'intérieur de l'accouplement de fluide (360), **caractérisé en ce que** le système de refroidissement (200) est réalisé sous la forme d'un module de refroidissement de base (200') qui comprend l'au moins une ligne de canal de refroidissement (225) sous la forme d'un système de canal de refroidissement de base (220), le système de canal de refroidissement de base (220) présentant au moins deux raccords secondaires (241, 242) au moyen desquels le système de canal de refroidissement de base (220) peut être étendu à l'extérieur du module de refroidissement de base (200') par une liaison détachable avec au moins un tronçon de refroidissement (145) d'un dispositif de refroidissement externe (140), **en ce que** les au moins deux raccords secondaires (241, 242) comprennent respectivement une soupape de passage (250) pour le fluide de refroidissement (310), la soupape de passage (310) étant réalisée pour, dans une première position d'actionnement (I), ouvrir le système de canal de refroidissement de base (220) pour un flux de fluide de refroidissement et, dans une deuxième position d'actionnement (II), fermer de manière étanche au fluide le système de canal de refroidissement de base (220), **en ce que** les soupapes de passage (250) des raccords secondaires (241, 242) présentent respectivement une zone de raccordement pour la liaison, notamment détachable, du système de canal de refroidissement de base (220) à un tronçon de refroidissement (145) d'un dispositif de refroidissement externe (140), la zone de raccordement respective étant réalisée sous forme d'élément complémentaire (361, 362) d'un accouplement de fluide (360) commun avec le dispositif de refroidissement externe (140), notamment sous forme d'accouplement de fermeture, dans lequel, dans une liaison accouplée entre le module de refroidissement de base (200') et le dispositif de refroidissement externe (140), la première position d'actionnement (I) peut être prise et, dans une liaison détachée entre le module de refroidissement de base (200') et le dispositif de refroidissement (140), la deuxième position d'actionnement (II) peut être prise, la première et la deuxième position d'actionnement (I, II) étant déterminées par une force élastique (FF), une force magnétique (FM) ou une force électrique (FE), en fonction d'un état d'accouplement avec l'élément complémentaire (361, 362) d'un dispositif de refroidissement externe (140).

11. Agencement de refroidissement (300') comprenant au moins un système de refroidissement (200) selon l'une quelconque des revendications 1 à 9, dans lequel au moins deux raccords secondaires (241, 242) sont reliés à un tronçon de refroidissement (145) d'un dispositif de refroidissement externe (140).
